# EUROPEAN PATENT APPLICATION

(11) **EP 3 437 772 A1**
(43) Date of publication of application: **06.02.2019**
(21) Application number: 17775221.9
(22) Date of filing: 29.03.2017
(51) Int. Cl.: B23B 27/14, C23C 16/32, C23C 16/34, C23C 16/36, C23C 16/40

(54) **SURFACE COATED CUTTING TOOL**

(30) Priority: 30.03.2016 JP 2016069629
(71) Applicant: Mitsubishi Materials Corporation, Chiyoda-ku Tokyo 100-8117 (JP)
(72) Inventor: DOBASHI Masataka, Tokyo 100-8117 (JP); MIYASHITA Dai, Tokyo 100-8117 (JP); KAWATA Yoshinori, Tokyo 100-8117 (JP); SAEKI Takushi, Tokyo 100-8117 (JP); OHMORI Hiroshi, Tokyo 100-8117 (JP); HARA Hisashi, Tokyo 100-8117 (JP); SHIBUYA Yoshitomo, Tokyo 100-8117 (JP); SOBANA Akira, Tokyo 100-8117 (JP)
(74) Representative: Gille Hrabal
(86) International application number: PCT/JP2017/012883
(87) International publication number: WO 2017/170687

(57) **Abstract**

Provided is a surface-coated cutting tool having excellent welding resistance and fracturing resistance during cutting work of carbon steel, alloy steel, and the like, and also having excellent chipping resistance and fracturing resistance particularly during intermittent cutting and the like. In a surface-coated cutting tool in which a hard coating layer including at least a lower layer and an upper layer is formed on a surface of a cutting tool body, (a) the lower layer is formed of one layer or two or more layers of a TiC layer, a TiN layer, a TiCN layer, a TiCO layer, and a TiCNO layer, and an Al₂O₃ layer as the upper layer is formed on a surface of the lower layer, and (b) on at least an outermost surface of the upper layer of a rake face, a zirconium oxide layer is formed in an area ratio of 30% to 70%, the Al₂O₃ layer on the rake face has a tensile residual stress of 10 to 200 MPa and a surface roughness Ra is 0.25 µm or less.

## Description

### Technical Field

The invention relates to a surface-coated cutting tool (hereinafter, simply referred to as "coated tool") having excellent welding resistance and fracturing resistance during cutting work of carbon steel, alloy steel, and the like, and also having excellent chipping resistance and fracturing resistance particularly during intermittent cutting and the like.

### Background Art

Hitherto, a coated tool provided with, on the surface of a body made of tungsten carbide (hereinafter, referred to as WC)-based cemented carbide or titanium carbonitride (hereinafter, referred to as TiCN)-based cermet (hereinafter, referred to as cutting tool body), a hard coating layer which includes a Ti compound layer formed of one layer or two or more layers of a Ti carbide layer (hereinafter, referred to as TiC), a Ti nitride layer (hereinafter, similarly referred to as TiN), a Ti carbonitride layer (hereinafter, referred to as TiCN), a Ti oxycarbide layer (hereinafter, referred to as TiCO), and a Ti oxycarbonitride layer (hereinafter, referred to as TiCNO) as a lower layer and an Al₂O₃ layer having an α-type crystal structure as an upper layer is known. In addition, various suggestions have hitherto been made for improving the cutting performance of the coated tool in which the hard coating layer is formed.

For example, in PTL 1, a suggestion has been made that a coated tool in which a lower layer formed of a hard material layer containing TiN, TiCN, and/or TiAlCNO and an upper layer formed of an α-Al₂O₃ layer having a specific preferred oriented structure are formed on the surface of a body, and the coated tool has excellent fracturing resistance by forming a wear recognition layer formed of a TiN layer, a TiC layer, a TiCN layer, or a combination thereof in the α-Al₂O₃ layer as the upper layer by chemical vapor deposition, and thereafter performing a blasting process on a rake face using a blasting material made of steel, glass, or ZrO₂ having a lower hardness than a granular blasting material made of corundum (α-Al₂O₃), which has been used in the related art and has high hardness, to achieve tensile stress relaxation in the α-Al₂O₃ layer after removal of the wear recognition layer and smoothness of the surface of the α-Al₂O₃ layer is obtained.

### Citation List

### Patent Literature

[PTL 1] Japanese Unexamined Patent Application Publication No. 2014-530112

### Summary of Invention

### Technical Problem

In the coated tool described in PTL 1, it is considered that since the blasting process is performed using the blasting material (average particle diameter 20 to 450 µm) made of ZrO₂ having a lower hardness than the granular blasting material made of corundum (α-Al₂O₃), which has been used in the related art and has high hardness, regarding projections present on the surface of the α-Al₂O₃ layer (that is, top portions of the particles of the surface of the α-Al₂O₃ layer) and recesses (that is, spaces between the particles of the surface of the α-Al₂O₃ layer), smoothing of the projections proceeds.

However, since the blasting material made of ZrO₂ has low hardness and poor grinding ability, sufficient abrasion is not performed at least on the recesses (that is, the spaces between the particles of the surface of the α-Al₂O₃ layer) of the surface of a coating, and smoothing does not proceed, which results in chipping from the recesses as start points, which are the spaces between the particles of the surface of the α-Al₂O₃ layer. Particularly, in a case where the chipping that has occurred in an initial stage of cutting grows, it is postulated that fatal fracturing may be incurred.

Here, there is a demand for a coated tool having further improved smoothness on the surface of a coating and further excellent welding resistance, chipping resistance, and fracturing resistance, as a coated tool.

### Solution to Problem

The inventors conducted intensive studies on the structure of a hard coating layer having further improved smoothness and further excellent welding resistance, chipping resistance, and fracturing resistance in a coated tool, and as a result, obtained the following knowledge.

That is, it was found that in a coated tool in which the surface of a cutting tool body is coated with at least an Al₂O₃ layer as a hard coating layer, in a case where zirconium oxide is introduced into recesses as spaces between particles on the outermost surface of an α-Al₂O₃ layer of a rake face, which are regarded as the above-described problem, and a zirconium oxide layer having an area ratio of 30% to 70% is formed on the outermost surface of the α-Al₂O₃ layer, the smoothness of the surface of the coating is further improved, so that a coated tool having further excellent welding resistance, chipping resistance, and fracturing resistance is obtained.

In addition, specifically, for example, this can be obtained by forming one layer or two or more layers of any of TiC, TiN, and TiCN as a lower layer on a rake face or a flank face of the cutting tool body, forming an Al₂O₃ layer as an upper layer on the lower layer, and then forming a zirconium layer having an area ratio of 30% to 70% on the rake face.

As necessary, a wear recognition layer formed of a TiN layer, a TiC layer, a TiCN layer, or a TiNO layer is formed on the outermost surface of the Al₂O₃ layer, the wear recognition layer on the rake face is removed, and a zirconium oxide layer is formed on the outermost surface of the rake face.

The film tool according to the present invention obtained as described above has excellent chipping resistance and fracturing resistance because, by adjusting blasting conditions regarding the rake face, the zirconium layer having an area ratio of 30% to 70% is formed on the surface of the Al₂O₃ layer to exclude the influence of defects on the outermost surface of the Al₂O₃ layer, the smoothness of the surface is further increased to improve welding resistance, and a reduction in residual stress can be achieved.

The present invention is made based on the above-described knowledge.
"(1) A surface-coated cutting tool in which a hard coating layer including at least a lower layer and an upper layer is formed on a surface of a cutting tool body made of WC-based cemented carbide or TiCN-based cermet, in which
   (a) the lower layer of the hard coating layer is formed of two or more layers of a TiC layer, a TiN layer, a TiCN layer, a TiCO layer, and a TiCNO layer (hereinafter, collectively referred to as a Ti compound layer), and an Al₂O₃ layer as the upper layer of the hard coating layer is formed on a surface of the lower layer of which at least one layer is formed of the TiCN layer, and
   (b) on at least an outermost surface of the upper layer of a rake face of the surface-coated cutting tool, a zirconium oxide layer is formed in an area ratio of 30% to 70%, the Al₂O₃ layer on the rake face has a tensile residual stress of 10 to 200 MPa and a surface roughness Ra is 0.25 µm or less.
(2) The surface-coated cutting tool according to (1), in which a tensile residual stress of the TiCN layer on the rake face is 10 to 250 MPa.
(3) The surface-coated cutting tool according to (1) or (2), in which the TiN layer, the TiC layer, the TiCN layer, or the TiNO layer is formed on an outermost surface of the Al₂O₃ layer as an upper layer of a flank face."

Hereinafter, a coated tool of the invention will be described in detail.

### Lower Layer

While the lower layer formed of the Ti compound layer is basically provided under the upper layer formed of the Al₂O₃ layer, the lower layer firmly adheres to both the cutting tool body and the upper layer, and thus acts to contribute to the improvement in adhesion of the hard coating layer to the cutting tool body, high hardness, which is a feature of the lower layer itself, enables the hard coating layer to have high wear resistance, and particularly excellent flank face wear resistance.

As a kind of film suitable for such a lower layer, a Ti compound layer of two or more layers of a TiC layer, a TiN layer, a TiCN layer, a TiCO layer, and a TiCNO layer can be employed, and at least one layer thereof included in the lower layer is the TiCN layer.

The average layer thickness of the lower layer is not particularly limited. However, when the average layer thickness is less than 3 µm, the above effect cannot be sufficiently exhibited. On the other hand, when the average layer thickness exceeds 20 µm, the fracturing resistance is adversely affected. Therefore, the average layer thickness of the lower layer is preferably set to 3 to 20 µm.

### Upper Layer

The upper layer formed of the Al₂O₃ layer improves the wear resistance of the coated tool due to its hardness, heat resistance and oxidation resistance. In the present invention, the layer thickness of the upper layer is not particularly limited. However, when the average layer thickness of the Al₂O₃ layer is less than 1 µm, excellent wear resistance cannot be exhibited for long-term usage. On the other hand, when the average layer thickness exceeds 15 µm, abnormal damage such as chipping, fracturing, and peeling is likely to occur. Therefore, it is desirable that the average layer thickness of the upper layer formed of the Al₂O₃ layer is set to 1 to 15 µm.

### Hard Coating Layer of Rake Face

The hard coating layer formed on the rake face is constituted by the lower layer formed of the Ti compound layer, the upper layer formed of the Al₂O₃ layer, and the zirconium oxide layer formed on the outermost surface in an area ratio of 30% to 70%.

According to an example of a method of producing a present invention coated tool, which will be described later, first, a Ti compound layer as a lower layer is formed on a rake face and a flank face of a cutting tool body, an Al₂O₃ layer as an upper layer is then formed on the surface of the lower layer, and a blasting process for increasing the surface smoothness of the Al₂O₃ layer and reducing the residual stress is thereafter performed on the rake face, whereby a zirconium oxide layer which covers the surface of the Al₂O₃ layer in an area ratio of 30% to 70% is formed and at the same time, the surface roughness Ra is adjusted to 0.25 µm or less, and preferably 0.20 µm or less, resulting in the improvement in chipping resistance and welding resistance.

In addition, after the blasting process, the residual stress in the Al₂O₃ layer is relaxed, and the value of the tensile residual stress is set to 10 to 200 MPa, and preferably 10 to 150 MPa, whereby the chipping resistance, fracturing resistance, and peeling resistance of the entire hard coating layer are improved.

Furthermore, by setting the value of the tensile residual stress of the TiCN layer to 10 to 250 MPa, and preferably 10 to 150 MPa, the chipping resistance, fracturing resistance, and peeling resistance of the entire hard coating layer are improved.

The area ratio of the zirconium oxide layer on the outermost surface of the Al₂O₃ layer of the rake face means an area ratio measured by performing SEM observation and EDS analysis on the rake face.

According to JIS B 0601: 2001, the surface roughness Ra of the rake face was measured using a stylus type surface roughness measuring instrument at a cut-off value of 0.08 mm, a reference length of 0.8 mm, and a scanning speed of 0.1 mm/sec.

The residual stress of the Al₂O₃ layer of the upper layer is measured by using an X-ray diffractometer using a sin²ψ method and Cuκα. For the measurement regarding α-Al₂O₃, a calculation is performed using the diffraction peak of a (13_10) plane, a Young's modulus of 384 GPa, and a Poisson's ratio of 0.232.

Similarly, the residual stress of the TiCN layer of the lower layer is calculated by using the diffraction peak of a (422) plane, and a calculation is performed using a Young's modulus of 480 GPa and a Poisson's ratio of 0.2.

### Hard Coating Layer of Flank Face

The hard coating layer formed on the flank face is constituted by the lower layer formed of the Ti compound layer, the upper layer formed of the Al₂O₃ layer, and as necessary, the wear recognition layer formed of a TiN layer, a TiC layer, a TiCN layer, or a TiNO layer formed on the outermost surface of the Al₂O₃ layer.

### Method of Producing Hard Coating Layer

The hard coating layer of the present invention can be produced, for example, by the following method.

First, a Ti compound layer as a lower layer and an Al₂O₃ layer as an upper layer are formed to have predetermined average layer thicknesses on the surface of a cutting tool body by a typical chemical vapor deposition method, and
thereafter, a TiN layer, a TiC layer, a TiCN layer, or a TiNO layer is formed on the outermost surface of the Al₂O₃ layer of the upper layer according to a typical chemical vapor deposition method so that the average layer thickness thereof becomes a layer thickness of about 0.1 to 1 µm.

Next, a wet blasting process is performed on the rake face, and a process is performed to remove the formed TiN layer, the TiC layer, the TiCN layer, or the TiNO layer in a case where these layers are formed on a rake face and to form a zirconium oxide layer that covers the outermost surface of the Al₂O₃ layer in an area ratio of 30% to 70%, thereby producing the hard coating layer.

### Blasting Process

Regarding the blasting process, more specific conditions are described, for example:
Blasting process solution: abrasive grains + water;
Abrasive grains: ZrO₂ grains;
Abrasive grain shape: spherical and/or polygonal;
Abrasive grain size (grain size): 125 to 425 µm (spherical)/< 125 µm (polygonal);
Abrasive grain ratio: 70 to 90 mass% (spherical)/10 to 30 mass% (polygonal);
Abrasive grain concentration: 20 vol% or less;
Blasting pressure: 0.10 to 0.35 MPa;
Projection angle with respect to the normal to the rake face: 0 to 20 degrees; and
Projection time: 5 to 30 seconds

Under these conditions, the blasting process is performed on the rake face, and particularly, by adjusting the abrasive grain shape, abrasive grain size, blasting pressure, projection angle, and the like, it is possible to adjust the residual stress of the Al₂O₃ layer of the upper layer and the area ratio of the zirconium oxide layer of the surface layer of the Al₂O₃ layer.

### Advantageous Effects of Invention

In the coated tool of the present invention, since the zirconium oxide layer is provided on the outermost surface of the Al₂O₃ layer as the upper layer on the rake face in an area ratio of 30% to 70%, the outermost surface achieves further smoothness, whereby the coated tool of the present invention exhibits excellent welding resistance and fracturing resistance, also excellent chipping resistance and fracturing resistance particularly during intermittent cutting and the like, and excellent cutting performance for long-term usage.

### Description of Embodiments

Next, the coated tool of the invention will be described in detail with reference to examples.

Although an example using WC-based cemented carbide as a cutting tool body is described, the same is also applied to a case where TiCN-based cermet is used as a cutting tool body.

### Example 1

As raw material powders, a WC powder, a TiC powder, a TiN powder, a TaC powder, a NbC powder, a Cr₃C₂ powder, and a Co powder, all of which had an average particle diameter of 1 to 3 µm, were prepared, and the raw material powders were mixed in mixing compositions shown in Table 1. Wax was further added thereto, and the mixture was blended in acetone by a ball mill for 24 hours and was decompressed and dried. Thereafter, the resultant was press-formed into compacts having predetermined shapes at a pressure of 98 MPa, and the compacts were sintered in a vacuum at 5 Pa under the condition that the compacts were held at a predetermined temperature in a range of 1370°C to 1470°C for one hour. After the sintering, cutting tool bodies A to C made of WC-based cemented carbide with insert shapes according to ISO CNMG 120408 were produced by performing honing with R: 0.05 mm on a cutting edge portion.

The cutting tool bodies were loaded in a typical chemical vapor deposition apparatus, and
first, under conditions shown in Table 2 (l-TiCN in Table 2 shows forming conditions of a TiCN layer having a longitudinally grown crystal structure described in JP-A-6-8010, and the others show forming conditions of a typical granular crystal structure), a Ti compound layer having a target layer thickness shown in Table 3 was deposited and formed as a lower layer of a hard coating layer.

Next, an Al₂O₃ layer and a TiN layer having target layer thicknesses shown in Table 3 were deposited on the surface of the lower layer under the conditions shown in Table 2.

Next, using ZrO₂ grains as abrasive grains, a wet blasting process was performed on a rake face under conditions shown in Table 4, thereby producing present invention coated tools 1 to 3 having the Al₂O₃ layer and a zirconium oxide layer of the rake face shown in Table 5.

The thicknesses of the lower layer and the upper layer of the present invention coated tools 1 to 3 were measured (longitudinal section measurement) using a scanning electron microscope and were found to be substantially the same average layer thicknesses as the target layer thicknesses (average value of five points measured).

SEM observation and EDS analysis were performed on the outermost surfaces of the Al₂O₃ layers of the present invention coated tools 1 to 3 to measure the area ratios of the zirconium oxide layers present on the surfaces of the Al₂O₃ layers on the rake faces.

Table 5 shows the measured area ratios of the zirconium oxide layers.

In addition, the surface roughnesses Ra of the rake faces of the present invention coated tools 1 to 3 produced as described above were measured.

The surface roughness Ra was measured according to JIS B 0601: 2001 using a stylus type surface roughness measuring instrument at a cut-off value of 0.08 mm, a reference length of 0.8 mm, and a scanning speed of 0.1 mm/sec.

Table 5 shows the results.

Furthermore, for the present invention coated tools 1 to 3 produced as described above, the residual stresses in the Al₂O₃ layers and the TiCN layers were measured.

The residual stress was measured by using an X-ray diffractometer using a sin²ψ method and Cuκα. For the measurement regarding α-Al₂O₃, a calculation was performed using the diffraction peak of a (13_10) plane, a Young's modulus of 384 Gpa, and a Poisson's ratio of 0.232. Regarding TiCN, a calculation was performed using the diffraction peak of a (422) plane, a Young's modulus of 480 Gpa, and a Poisson's ratio of 0.2. Table 5 shows the results.

**[Table 1]**

| Raw material type | Mixing composition (mass%) | | | | | |
|---|---|---|---|---|---|---|
| | Co | TiC | TiN | TaC | NbC | WC |
| A | 7.5 | - | - | - | - | Remainder |
| B | 8.0 | - | - | 1.7 | 2.9 | Remainder |
| C | 9.0 | 2.2 | 2.0 | - | 2.4 | Remainder |

**[Table 2]**

| Hard coating layer | | Forming conditions (pressure of reaction atmosphere is expressed as kPa and temperature is expressed as °C). | | |
|---|---|---|---|---|
| Type | Formatio n symbol | Reaction gas composition (vol%) | Reaction atmosphere | |
| | | | Pressur e | Temperature e |
| TiC layer | TiC | TiCl₄:4.2%,CH₄:8.5%,H₂: remainder | 7 | 1020 |
| TiN layer (first layer) | TiN | TiCl₄:4.2%,N₂:30%,H₂: remainder | 30 | 900 |
| TiN layer (other layers ) | TiN | TiCl₄:4.2%,N₂:35%,H₂: remainder | 50 | 1040 |
| l-TiCN layer | l-TiCN | TiCl₄:4.2%,N₂:20%,CH₃CN:0.6%,H₂: remainder | 7 | 900 |
| TICO layer | TiCO | TiCl₄:4.2%,CO:4%,H₂: remainder | 7 | 1020 |
| TiCNO layer | TiCNO | TiCl₄:4.2%,CO:4%,CH₄:3%,N₂:20%,H₂: remainder | 20 | 1020 |
| α-type Al₂O₃ layer | α | AlCl₃:2.2%,CO₂:5.5%,HCl:2.2%,H₂S:0.2%, H₂: remainder | 7 | 1000 |

**[Table 3]**

| Type | | Chip body number | Hard coating layer | | | | | |
|---|---|---|---|---|---|---|---|---|
| | | | Lower layer (Ti compound layer) (target layer thickness: µm is indicated in parentheses) | | | | Average layer of Al₂O₃ layer (µm) | Wear recognition layer (µm) |
| | | | First layer | Second layer | Third layer | Fourth layer | | |
| Present invention coated tool | 1 | A | TiN (0.2) | 1-TiCN (8.5) | TiCO (0.5) | - | 6 | - |
| | 2 | B | TiN (0.5) | 1-TiCN (7.5) | TiCNO (0.5) | - | 8 | - |
| | 3 | C | TiC (0.5) | TiN (0.5) | 1-TiCN (7) | TiCNO (0.5) | 7.5 | TiN (0.2) |

**[Table 4]**

| Wet blasting type | Processing conditions | | | | | | | |
|---|---|---|---|---|---|---|---|---|
| | Processing solution | Abrasive grain shape | Abrasive grain size (grain size µ) | Mass ratio (mass%) | Abrasive grain concentration (vol%) | Blasting pressure (MPa) | Blasting time (sec) | Projection angle with respect to normal to rake face (degrees) |
| A | Abrasive grains + water | Spherica 1 | 150 to 210 | 75 | 15 | 0.20 | 15 | 0 |
| | | Polygona 1 | <125 | 25 | | | | |
| B | Abrasive grains + water | Spherica 1 | 210 to 300 | 90 | 8 | 0.30 | 9 | 10 |
| | | Polygona 1 | <125 | 10 | | | | |
| C | Abrasive grains + water | Spherica 1 | 300 to 425 | 80 | 10 | 0.25 | 11 | 5 |
| | | Polygona 1 | <125 | 20 | | | | |

**[Table 5]**

| Type | | Wet blasting process type | Hard coating layer (rake face) | | | |
|---|---|---|---|---|---|---|
| | | | Area ratio of zirconium oxide layer | Surface roughness (Ra) | Residual stress in TiCN layer (MPa) | Residual stress in Al₂O₃ (MPa) |
| Present invention coated tool | 1 | A | 62 | 0.23 | 88 | 110 |
| | 2 | B | 35 | 0.15 | 110 | 82 |
| | 3 | C | 51 | 0.17 | 98 | 55 |

For the purpose of comparison, a Ti compound layer having a target layer thickness shown in Table 6 was deposited as a lower layer of a hard coating layer on the cutting tool bodies A to C made of WC-based cemented carbide produced as described above under conditions shown in Table 2, and thereafter, an Al₂O₃ layer and a TiN layer having target layer thicknesses shown in Table 6 were deposited on the surface of the lower layer under the conditions shown in Table 2.

Next, a blasting process was performed on a rake face under conditions shown in Table 7, thereby producing comparative example coated tools 1 to 3 having an Al₂O₃ layer on the rake face shown in Table 8.

SEM observation and EDS analysis were performed on the outermost surfaces of the Al₂O₃ layers of the comparative example coated tools 1 to 3 to measure the area ratios of zirconium oxide layers present on the surfaces of the Al₂O₃ layers on the rake faces.

Table 8 shows the measured area ratios of the zirconium oxide layers.

In addition, for the comparative example coated tools 1 to 3 produced as described above, the surface roughness Ra of the rake face was measured in the same method as the present invention coated tools 1 to 3, and furthermore, the residual stresses in the Al₂O₃ layers and the TiCN layers were measured.

Table 8 shows the results.

**[Table 6]**

| Type | | Chip body number | Hard coating layer | | | | | |
|---|---|---|---|---|---|---|---|---|
| | | | Lower layer (Ti compound layer) (target layer thickness: µm is indicated in parentheses) | | | | Average layer thickness of Al₂O₃ layer (µm) | Wear recognition layer (µm) |
| | | | First layer | Second layer | Third layer | Fourth layer | | |
| Comparative example coated tool | 1 | Same as present invention coated tool 1 | | | | | | |
| | 2 | Same as present invention coated tool 2 | | | | | | |
| | 3 | Same as present invention coated tool 3 | | | | | | |

**[Table 7]**

| | Processing conditions | | | | | | | |
|---|---|---|---|---|---|---|---|---|
| | Processing solution | Abrasive grain shape | Abrasive grain size (grain size µm) | Mass ratio (mass%) | Abrasive grain concentration (vol%) | Blasting pressure (MPa) | Blasting time (sec) | Projection angle with respect to normal to rake face (degrees) |
| a | Abrasive grains + water | Polygonal | 125 to 250 | 100 | 12 | 0.15 | 18 | 0 |
| b | Abrasive grains + water | Spherical | 150 to 210 | 100 | 20 | 0.20 | 7 | 0 |
| c | Abrasive grains + water | Spherical | 210 to 300 | 80 | 15 | 0.25 | 12 | 60 |
| | | Polygonal | <125 | 20 | | | | |

**[Table 8]**

| Type | | Wet blasting process type | Hard coating layer (rake face) | | | |
|---|---|---|---|---|---|---|
| | | | Area ratio of zirconium oxide layer | roughness (Ra) | Residual stress in TiCN layer (MPa) | Residual stress in Al₂O₃ layer (MPa) |
| Comparative example coated tool | 1 | a | 23 | 0.27 | 310 | 280 |
| | 2 | b | 9 | 0.35 | 180 | 162 |
| | 3 | c | 15 | 0.30 | 210 | 175 |

Next, in a state in which each of the present invention coated tools 1 to 3 and the comparative example coated tools 1 to 3 was screwed to a tip end portion of an insert holder made of tool steel by a fixing tool, a cutting test was conducted under the following cutting conditions A and cutting conditions B.

### <<Cutting Conditions A>>

Work material: a round bar of JIS S45C
Cutting speed: 250 m/min
Depth of cut: 1.5 mm
Feed: 0.25 mm/rev
Cutting time: 10 minutes

A dry cutting test of carbon steel under above conditions.

### <<Cutting Conditions B>>

Work material: a round bar with four straight grooves formed at equal intervals in the longitudinal direction according to JIS SNCM439
Cutting speed: 150 m/min
Depth of cut: 3.0 mm
Feed: 0.25 mm/rev
Cutting time: 6 minutes

A dry intermittent cutting test of alloy steel under above conditions.

In the above cutting tests, presence or absence of occurrence of welding, presence or absence of occurrence of chipping, and presence or absence of occurrence of fracturing were observed. Table 9 shows the results of the cutting tests.

**[Table 9]**

| Type | | Cutting work test results | | | Type | | cutting work test results | | |
|---|---|---|---|---|---|---|---|---|---|
| | | <<Cutting conditions A>> | | <<Cutting conditions B>> | | | <<Cutting conditions A>> <<Cutting conditions B>> | | |
| | | Presence or absence of occurrence of welding | Presence or absence of occurrence of chipping | Presence or absence of occurrence of fracturing | | | Presence or absence of occurrence of welding | Presence or absence of occurrence of chipping | Presence or absence of occurrence of fracturing |
| Present invention coated tool | 1 | Absent | Absent | Absent | Comparative example coated tool | 1 | Present | Present | Fractured within 1.1 minutes |
| | 2 | Absent | Absent | Absent | | 2 | Present | Present | Fractured within 3.1 minutes |
| | 3 | Absent | Absent | Absent | | 3 | present | Present | Fractured within 2.4 minutes |

From the results shown in Tables 5, 8 and 9, it can be understood that the present invention coated tools have the zirconia oxide layer on the outermost surface of the Al₂O₃ layer as the upper layer of the rake face in an area ratio of 30% to 70% and thus have excellent welding resistance, chipping resistance, and fracturing resistance.

Contrary to this, in any of the comparative example coated tools, no zirconium oxide layer is formed on the outermost surface of the Al₂O₃ layer as the upper layer of the rake face, or even if the zirconia oxide layer is formed, the area ratio thereof is less than 30%. As a result, it cannot be said that sufficient cutting performance is exhibited regarding welding resistance, chipping resistance, and fracturing resistance.

### Industrial Applicability

As described above, the coated tool according to the present invention has excellent cutting performance, so that a reduction in costs and high workability can be realized by high performance of a cutting apparatus and power saving and energy saving during cutting work.

## Claims

1. A surface-coaced cutting tool in which a hard coating layer including at least a lower layer and an upper layer is formed on a surface of a cutting tool body made of WC-based cemented carbide or TiCN-based cermet, wherein
(a) the lower layer of the hard coating layer is formed of two or more layers of a TiC layer, a TiN layer, a TiCN layer, a TiCO layer, and a TiCNO layer (hereinafter, collectively referred to as a Ti compound layer), and an Al₂O₃ layer as the upper layer of the hard coating layer is formed on a surface of the lower layer of which at least one layer is formed of the TiCN layer, and
(b) on at least an outermost surface of the upper layer of a rake face of the surface-coated cutting tool, a zirconium oxide layer is formed in an area ratio of 30% to 70% the Al₂O₃ layer on the rake face has a tensile residual stress of 10 to 200 MPa and a surface roughness Ra is 0.25 µm or less.

2. The surface-coated cutting tool according to claim 1, wherein
a tensile residual stress of the TiCN layer on the rake face is 10 to 250 MPa.

3. The surface-coated cutting tool according to claim 1 or 2, wherein
the TiN layer, the TiC layer, the TiCN layer, or the TiNO layer is formed on an outermost surface of the Al₂O₃ layer as an upper layer of a flank face.
